(19) Europäisches Patentamt / European Patent Office / Office européen des brevets

(11) **EP 3 235 124 B1**

(12) **FASCICULE DE BREVET EUROPEEN**

(45) Date de publication et mention de la délivrance du brevet:
**10.10.2018 Bulletin 2018/41**

(21) Numéro de dépôt: **15808645.4**

(22) Date de dépôt: **15.12.2015**

(51) Int Cl.:
*H03F 1/02* (2006.01)    *H03F 3/19* (2006.01)

(86) Numéro de dépôt international:
**PCT/EP2015/079687**

(87) Numéro de publication internationale:
**WO 2016/096783 (23.06.2016 Gazette 2016/25)**

(54) **CHAÎNE DE RÉCEPTION DE SIGNAUX ELECTROMAGNÉTIQUES IMPULSIONNELS**

EMPFANGSKETTE FÜR ELEKTROMAGNETISCHE IMPULSSIGNALE

RECEIVER CHAIN FOR ELECTROMAGNETIC PULSE SIGNALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2014 FR 1402881**

(43) Date de publication de la demande:
**25.10.2017 Bulletin 2017/43**

(73) Titulaire: **Thales**
**92400 Courbevoie (FR)**

(72) Inventeurs:
• **GARREC, Patrick**
  **33600 Pessac (FR)**
• **PLAZE, Jean-Philippe**
  **33600 Pessac (FR)**
• **MALLET-GUY, Benoît**
  **33600 Pessac (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**US-A1- 2009 042 527    US-A1- 2009 215 420**
**US-A1- 2012 169 424    US-A1- 2013 307 615**

**EP 3 235 124 B1**

**Description**

La présente invention concerne une chaîne de réception de signaux électromagnétiques impulsionnels, de systèmes d'écoute radar, applications dites ESM (Electronics Support Measures). L'invention s'applique notamment pour les amplificateurs faible bruit et pour les divers organes de réception électroniques de systèmes d'écoute radar. Elle concerne particulièrement les systèmes d'antennes multifonctions et les réseaux ou antennes à balayage électronique.

Dans les chaînes de réception, les amplificateurs faible bruits, appelés par la suite LNA (Low Noise Amplifier) posent des problèmes de consommation d'énergie. Ces problèmes de consommation sont notamment aigus lorsque ces LNA sont réalisés en technologie GaN, car cette technologie nécessite des tensions de fonctionnement élevées, supérieures à 10 volts, ce qui ne fait qu'augmenter la consommation.

Cette consommation importante des LNA est principalement liée à des exigences de linéarité. Une raison du besoin de linéarité réside dans la nécessité de limiter la saturation ainsi que les harmoniques et les produits de modulation liés à ces saturations et non linéarités.

Les harmoniques sont les multiples fréquentiels des signaux forts à n fois la fréquence initiale. En cas de large bande ces signaux parasites sont contenus dans la bande passante utile et sont gênants pour le traitement du signal en sortie de réception. Les autres problèmes connus sont les produits d'intermodulation qui sont générés en cas de non linéarité. Ils apparaissent en présence de deux signaux faiblement espacés en fréquence. On caractérise la mesure de ces produits par un développement polynomial basé sur les suites de Taylor, le troisième ordre correspondant au troisième produit de la suite de Taylor. La mesure est caractérisée par ce troisième ordre et est connu sous le nom d'IP3 ou TOI (Third Order Intercept).

Dans le cas d'un amplificateur large bande, par exemple avec un rapport 4, la réception d'un signal fort $F_0$ et d'un signal faible à une autre fréquence génère des harmoniques liées à la distorsion, distorsion qui est causée par la non linéarité de l'amplificateur. La non linéarité peut alors être assimilée à un mélangeur et donner des produits de mélange entre la fréquence du signal fort et les harmoniques : $F_0 + f_1$, $F_0 + 2f_1$, ... $F_0 + nf_1$, ... Plus la bande passante est importante, plus l'effet sera important.

Une nécessité opérationnelle des LNA est leur robustesse face aux agressions externes. Les effets de ces agressions sont souvent limités par la technologie utilisée et la valeur de la tension d'alimentation. Plus la tension d'alimentation est importante, plus le composant est résistant mais plus il consomme d'énergie. Cette consommation est liée à la classe de l'amplification et aux courants et tensions employés pour éviter les saturations en présence de courants forts.

Les technologies qui permettent une réception large bande et une dynamique importante sont récentes, une dynamique importante correspondant à une large plage de valeurs de fonctionnement en entrée du LNA. Cependant ces technologies sont fortement consommatrices de courant si l'on souhaite une linéarité sur toute la bande de fréquence. L'usage d'amplificateurs logarithmiques dans les détecteurs de radar permet d'obtenir des dynamiques importantes au détriment de la linéarité.

L'usage d'amplificateurs à bande étroite permet d'obtenir des linéarités sur des plages de fonctionnement importantes sans être perturbé par les échos des harmoniques d'ordre 2 et supérieurs, ou des signaux hors bande utile. Le besoin d'avoir des systèmes multifonction, notamment pour minimiser les ouvertures antennaires est maintenant une nécessité pour compacter les senseurs. Les progrès de la technologie permettent d'amplifier des signaux occupant une large bande de fréquence et de grande dynamique. Cependant, un prix à payer pour conjuguer ces deux avantages est la consommation des LNA qui tend à devenir très significative lorsque l'on est en présence d'une antenne réseau et qu'il y a autant de LNA que de modules actifs. On peut même atteindre un paradoxe dans le fait que la partie réception consomme plus que la partie émission.

Dans des solutions connues, le problème d'absence de robustesse est traité par des circulateurs hyperfréquence qui protègent la sorties des amplificateurs de puissance en dirigeant les signaux vers une charge. Pour les LNA, des diodes de protection placées en amont permettent d'augmenter la résistance jusqu'aux limites de ces circuits de protection avec comme conséquence des pertes d'insertion importantes qui affectent directement le facteur de bruit de la chaîne de réception.

Il existe également des solutions avec une contre réaction linéaire entre la sortie amplifiée et le point de polarisation des transistors des LNA. Ces solutions sont plus lentes en temps de réaction et il est plus difficile d'avoir des plages de compensation linéaire de grande valeur et des lois reproductibles. De plus, les gains des petits signaux ne sont pas constants en fonction des courants de polarisation. Dans le cas d'une réception d'impulsions radar, qui sont d'amplitude constantes, cela entraîne une erreur sur la phase détectée.

Le problème de consommation d'énergie en excès se pose de façon saillante dans le cas d'une application ESM où les signaux reçus sont rarement saturant. Cependant les tensions d'alimentation et les courants drains des LNA sont réglés aux valeurs maximum pour être adaptés aux signaux saturant, ces tensions et ces courants étant surdimensionnés pour les autres signaux, d'où une perte d'énergie inutile par LNA. En langage imagé, on peut dire que les LNA fonctionnent à « plein régime » pour uniquement une faible quantité de signaux saturant. Quantitativement, si on estime à 3W l'ordre de grandeur de la puissance consommée par LNA, on peut atteindre une puissance globale de 3 kW pour un système comportant 1000 LNA.

Un document US2013/307615 A1 divulgue un convertisseur de tension dans lequel la tension d'alimentation de l'amplificateur de puissance varie avec la puissance de sortie. Un document US2009/042527 A1 divulgue un récepteur basse puissance. Un document US2009/215420 A1 divulgue un procédé de contrôle du bruit dans un récepteur RF.

Un but de l'invention est notamment de limiter ce gaspillage d'énergie, et diminuer aussi les contraintes induites par une telle consommation sans les inconvénients de l'art antérieur, les contraintes induites étant notamment la génération de l'énergie et son acheminement et le refroidissement des pertes liées au rendement qui sont proportionnelles à la consommation.

A cet effet, l'invention a pour objet une première chaîne de réception de signaux électromagnétiques impulsionnels et une deuxième chaîne de réception de signaux électromagnétiques impulsionnels telles que décrites par les revendications.

D'autres caractéristiques et avantages de l'invention apparaîtront à l'aide de la description qui suit, faite en regard de dessins annexés qui représentent :

- La figure 1, une illustration du principe de l'invention, par un exemple de réalisation d'un circuit d'asservissement de la tension d'alimentation et/ou du courant de polarisation d'un LNA ;
- La figure 2, un exemple de réalisation possible d'un circuit d'asservissement de la tension d'alimentation d'un LNA pour la mise en oeuvre de l'invention ;
- La figure 3, un exemple de réalisation possible d'un circuit d'asservissement du courant de polarisation d'un LNA pour la mise en oeuvre de l'invention ;
- Les figures 4a à 4c, une illustration des effets de commutation par paliers de la tension d'alimentation d'un LNA ;
- Les figures 5a à 5c, des courbes illustrant respectivement la variation du gain en puissance, du facteur de bruit et des performances de linéarité ;
- Les figures 6a et 6b, une illustration de la commutation du signal pour plusieurs niveaux de tension de polarisation d'un LNA ;
- La figure 7, une illustration du signal de sortie d'un LNA en fonction du signal d'entrée pour différentes valeurs de tensions d'alimentation et de courant de polarisation d'un LNA.

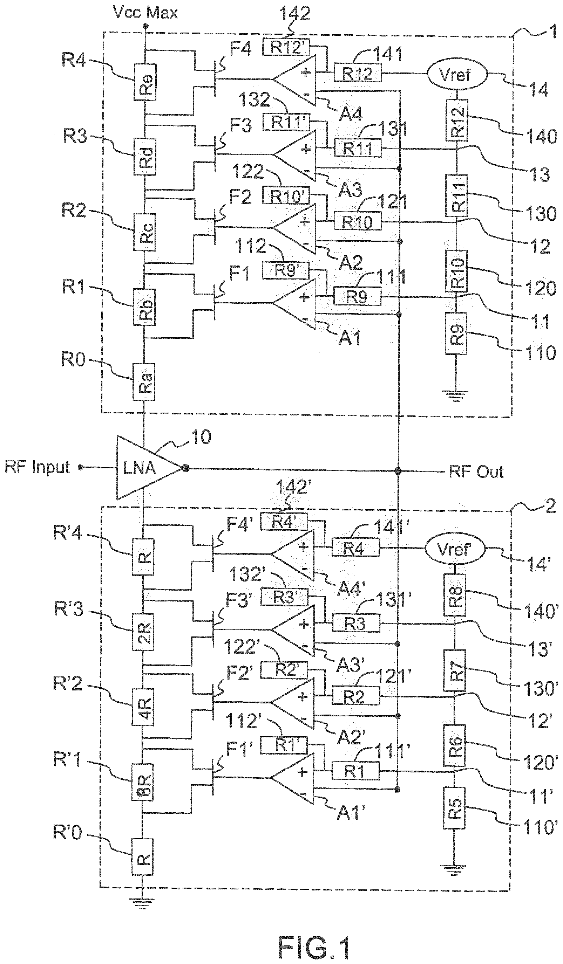

La figure 1 illustre par un schéma le principe de l'invention. Un amplificateur faible bruit 10, appelé également par la suite LNA, est placé dans une chaîne de réception d'écoute de signaux radar. Le LNA reçoit en entrée les signaux hyperfréquence, ou RF, captés par les antennes du système. Le LNA est couplé à un circuit d'asservissement 1, 2 de la tension d'alimentation du LNA et/ou de son courant de polarisation en fonction de l'amplitude du signal reçu en sortie du LNA. Une première partie 1 effectue un asservissement de la tension d'alimentation et une deuxième partie 2 effectue un asservissement du courant de polarisation du LNA. L'invention consiste notamment à optimiser la consommation des LNA, c'est-à-dire à augmenter l'IP3 uniquement à bon escient, en temps réel, en adaptant la tension d'alimentation et/ou le courant de polarisation aux amplitudes des signaux RF reçus.

Le principe de l'invention repose donc sur une gestion appropriée de la consommation, fonction de la tension d'alimentation et/ou du courant de polarisation du LNA, en prenant en compte les contraintes de linéarité uniquement en cas d'apparition de signaux forts. On obtient alors un LNA qui se comporte comme un amplificateur de petits signaux et qui, en cas de besoin, commute en amplificateur de signaux forts au moyens du circuit d'asservissement 1, 2. La tension d'alimentation ou le courant de polarisation du LNA commutent par paliers, c'est-à-dire qu'ils peuvent prendre un nombre donné de valeurs. Par exemple la tension d'alimentation peut prendre les trois valeurs suivantes : 10 V, 15 V et 20 V. Le courant de polarisation peut prendre les trois valeurs suivantes : 100 mA, 150 mA et 200 mA.

Par les circuits d'asservissement 1, 2 les courants de polarisation et les tensions d'alimentation peuvent être commutés pour s'adapter à la dynamique des signaux.

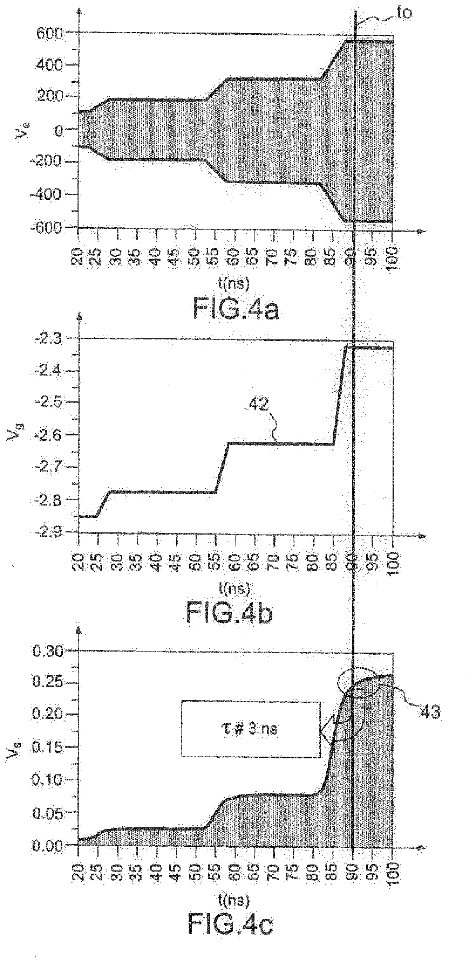

Les non linéarités et les distorsions n'apparaîtront que pendant les phases de commutation de seuils comme décrit ci-après en regard des figures 4a, 4b et 4c. Une commutation de seuil correspond au passage d'une valeur de tension d'alimentation à une autre ou d'une valeur de courant de polarisation à une autre. Les phases de commutation sont localisées et peuvent faire l'objet d'un post traitement. En particulier, les largeurs d'impulsion peuvent être compensées en fonction de l'amplitude mesurée. La loi de compensation en amplitude et les corrections de largeur d'impulsions sont dans ce cas tabulées sur un faible nombre de valeurs.

On rappelle que le LNA 1 doit combiner un facteur de bruit faible avec un gain donné et une grande stabilité dans une grande bande de fréquence, la stabilité correspondant à une absence d'oscillations. Ce type d'amplificateur est souvent en classe A, avec typiquement 20% du courant utile servant à polariser l'amplificateur, de façon à placer le point de repos au centre des possibilités d'évolution en tension et en courant tout en restant dans la zone linéaire.

Un besoin notable dans les circuits d'amplification faible bruit à large bande est de ne pas saturer et de rester linéaire sur une grande dynamique. Ceci pour permettre une amplification des petits et des grands signaux. Le fait d'avoir un très bon facteur de bruit, un grand gain et une stabilité sur toute la bande de fréquences tout en consommant peu revient à résoudre la quadrature du cercle. La linéarité a un coût énergétique car elle exige une tension d'alimentation élevée et des courants de polarisation forts pour rester dans la zone linéaire. Une stabilité parfaite se fait au détriment du gain. Des niveaux d'IP3 importants imposent des courants de polarisation forts, bien que les meilleurs facteurs de bruit soient obtenus avec des courants faibles. Le problème se complexifie en sachant que la température et le facteur de bruit sont en opposition, traduisant le fait que plus le composant est chaud et moins bon est le facteur de bruit. Les paramètres à traiter sont la bande de fréquences, le courant continu et le biais en tension avec la dissipation, la stabilité et le gain, l'adaptation en entrée et en sortie, et le découplage des alimentations pour éviter le bruit ramené au niveau de l'amplificateur.

Le facteur de bruit *Fb* d'une chaîne d'amplification se calcule par la formule suivante :

$$Fb = Fb1 + \frac{Fb2-1}{G1} + \frac{Fb3-1}{G1.G2} + ... \qquad (1)$$

*Fb*1, *Fb*2, *Fb*3 ... étant respectivement les facteurs de bruit de la première chaîne, de la deuxième chaîne, de la troisième chaîne et ainsi de suite. *G*1, *G*2, *G*3 ... sont les gains associés respectivement à ces mêmes chaînes. La relation (1) montre que le facteur de bruit du premier élément de la chaîne *Fb*1 peut être plus ou moins prépondérant selon la valeur des gains, notamment du gain *G*1 de la première chaîne d'amplification. Ce gain *G*1 joue donc un rôle très important pour le facteur de bruit *Fb* de la chaîne globale. Plus ce gain est grand, plus on risque de saturer la chaîne de réception mais meilleur est le facteur de bruit *Fb* puisque les facteurs de bruits des autres chaînes sont atténuées par *G*1. Dans l'exemple du dispositif de la figure 1, c'est donc le gain du LNA 1 qui est le paramètre clé. La commande du LNA 1 doit donc faire en sorte que celui-ci reste en fonctionnement linéaire mais de ne surconsommer qu'en présence de signaux forts. Il faut aussi optimiser le facteur de bruit quand les signaux à recevoir sont très faibles.

On revient à la figure 1 qui présente un exemple de réalisation du circuit d'asservissement. Une fonction du circuit d'asservissement 1, 2 est donc de permettre au LNA de rester linéaire et de ne consommer une puissance importante qu'en présence de signaux forts. Si les niveaux de signaux reçus sont très forts, pour éviter de saturer et par là-même d'avoir des harmoniques dont on ne peut s'affranchir, selon l'invention on augmente la tension d'alimentation dynamiquement pour éloigner le LNA de la tension coude au maximum, la tension coude correspondant au début de la saturation. Cette fonction d'asservissement de la tension d'alimentation en fonction de l'amplitude du signal reçu est assurée par la première partie 1 du circuit d'asservissement. Une autre possibilité d'éviter la saturation est d'augmenter le courant de polarisation dont l'asservissement est réalisé par la deuxième partie 2 du circuit d'asservissement.

Dans l'exemple de la figure 1, la première partie 1 du circuit d'asservissement comporte quatre tensions de seuil 11, 12, 13, 14 obtenues par exemple à partir d'une tension de référence Vref 14 et un jeu de ponts diviseurs utilisant quatre résistances 110, 120, 130, 140 reliées en série entre la tension de référence et un potentiel de masse, les valeurs des tensions des tensions de seuil étant définies par les valeurs des résistances. Ces tensions de seuils sont reliées à l'entrée positive d'un amplificateur A1, A2, A3, A4 monté en suiveur via deux résistances formant de façon connue des comparateurs à hystérésis ou trigger de Schmitt. Plus particulièrement, une première résistance 111 est reliée entre la tension de seuil 11 et l'entrée non inversée du comparateur et une deuxième résistance 112 est reliée entre l'entrée non inversée et la sortie. Il en est de même pour la connexion des autres résistances 121, 122, 131, 132, 141, 142 sur les autres amplificateurs A2, A3, A4.

Les sorties des amplificateurs commandent chacune un commutateur F1, F2, F3, F4. Ces transistors étant par exemple des transistors à effet de champs (FET), les sorties des amplificateurs sont connectés sur les grilles des transistors. Cinq résistances R0, R1, R2, R3, R4 sont connectées en série entre une tension d'alimentation Vcc$_{max}$ et le LNA. Quatre résistances R1, R2, R3, R4 sont associées chacune à un transistor F1, F2, F3, F4, dans ce sens que les bornes d'une résistance sont connectées entre le drain et la source de son transistor associé, de sorte qu'un transistor activé, c'est-à-dire à l'état fermé, court-circuite sa résistance associée.

Une dernière résistance R0 est connectée entre le LNA et le premier transistor F1. Les entrées inversées des amplificateurs sont reliées à la sortie du LNA. Une comparaison du signal reçu par le LNA peut donc être réalisée avec les différentes tensions de seuil 11, 12, 13, 14. La mesure est faite en sortie du LNA pour éviter de détériorer le facteur de bruit du récepteur. Elle pourrait être faite cependant en entrée du LNA. En regard des courants mis en jeu dans les drains du LNA, la consommation des comparateurs est négligeable.

L'ensemble des commutateurs F1, F2, F3, F4 est donc commandé par la tension de sortie du LNA, correspondant à l'amplitude des signaux reçus, au moyen des amplificateurs montés en suiveur, formant chacun un comparateur à hystérésis ou trigger de Schmitt permettant d'éviter les oscillations autour de valeurs de sorties lors de la commutation.. Les comparateurs sont étagés pour, par exemple réagir sur des multiples de 2 de la consommation. On peut donc par exemple avoir une hystérésis égale à la moitié de la valeur de l'amplitude détectée avant de descendre la valeur de consigne. Les valeurs des tensions 11, 12, 13, 14 sont établies pour favoriser une adaptation de la consommation au milieu. Plus il y a de valeurs de tension, plus fine est l'optimisation.

Par la suite, on considère que les commutateurs sont des transistors FET. Ceux-ci sont commandés de telle sorte qu'ils commutent en fermeture lorsque les tensions de seuil qui leur sont associées sont franchies. Ainsi, si on note V1, V2, V3, V4 respectivement les valeurs des tensions de seuil 11, 12, 13, 14, le transistor F1 se ferme lorsque l'amplitude de sortie du LNA dépasse la valeur V1, le transistor F2 se ferme à son tour lorsque l'amplitude dépasse la valeur V2 et ainsi de suite. Lorsque l'amplitude est inférieure à V1, tous les transistors sont ouverts, et toutes les résistances R0, R1, R2, R3, R4 sont présentes, c'est-à-dire parcourues par un courant. Lorsque l'amplitude dépasse V1, le transistor F1 court-circuite la résistance R1 par sa fermeture qui n'intervient plus dans la tension d'alimentation du LNA. Il en est de même avec la fermeture des autres transistors F2, F3, F4.

Dans l'exemple de la figure 1, le circuit d'asservissement 2 du courant de polarisation a la même structure que le circuit d'asservissement 1 de la tension d'alimentation. Les composants sont par exemple les mêmes. Sur la figure 1, ces composant sont identifiés par les même numéros complétés du signe ' . Par exemple la première tension de seuil est référence 11' alors qu'elle est référencée 11 dans la première partie 1. Conformément au fonctionnement précédent, les transistors F1', F2', F3', F4' se ferment successivement lorsque l'amplitude du signal dépasse les seuils 11', 12', 13', 14' ayant respectivement les valeurs suivantes V1, V2, V3 et V4. Les résistances R1', R2', R3', R4' sont reliées en série à une résistance R0' elle-même reliée à la masse. Le courant de polarisation est chargé par ces résistances qui déterminent donc sa valeur. Le dépasse d'un seuil par la tension de sortie du LNA commande le transistor associé de tel sorte qu'il court-circuite sa résistance.

On considère un exemple où l'on souhaite multiplier par 4 le courant de polarisation et gagner 24dB de dynamique sur les signaux forts.

Pour obtenir un doublement du courant de polarisation à chaque franchissement de seuil, on prend pour les résistances R0', R1', R2', R3', R4' les valeurs suivantes :

- R0' = R
- R1' = 8R
- R2' = 4R
- R3' = 2R
- R4' = R.

La valeur R est définie pour que le courant passe de la valeur 80 mA à 320 mA au cours des franchissements de seuils successifs.

Quand l'amplitude du signal de sortie du LNA est inférieure à V1, toutes les résistances R0', R1', R2', R3', R4' formant la résistance de drain sont présentes, c'est-à-dire que le courant de polarisation passe dans toutes ces résistances, tous les transistors F1', F2', F3', F4' étant ouverts. La résistance totales est 16R, R étant dimensionnée pour obtenir 80 mA.

Dès que l'amplitude du signal de sortie du LNA dépasse V1, le transistor F1' se ferme et court-circuite la résistance R1' et la résistance de drain passe à 8R.

Dès que l'amplitude du signal de sortie du LNA dépasse V2, le transistor F2' se ferme également et court-circuite la résistance R2' et la résistance de drain passe à 4R.

Dès que l'amplitude du signal de sortie du LNA dépasse V3, le transistor F3' se ferme et court-circuite aussi la résistance R3' et la résistance de drain passe à 8R.

Si l'amplitude monte au-delà de V4, égal à Vref, la résistance de drain devient R, on obtient alors l'intensité maximum du courant de drain de 360 mA, appliqué pour les signaux les plus forts.

On peut prendre V1 = 1/4 V2, V2 = 1/4 V3 et V3 = 1/4 V4.

Le circuit d'asservissement peut comporter les deux parties 1, 2. Dans ce cas, on peut réaliser un asservissement en tension d'alimentation et en courant de polarisation. Il peut aussi comporter l'une ou l'autre de ces parties, c'est-à-dire soit un circuit d'asservissement en tension, soit un circuit d'asservissement en courant.

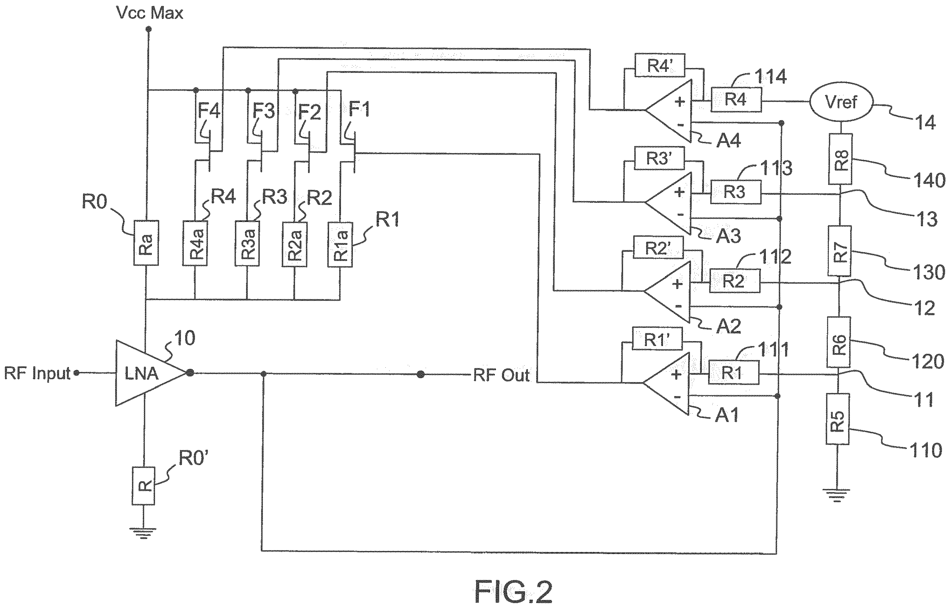

La figure 2 illustre un autre mode de mise en oeuvre possible de l'invention où le circuit d'asservissement est en tension uniquement. Dans ce mode de réalisation les comparateurs constitués des amplificateurs A1, A2, A3, A4 montés en suiveur sont étagés comme dans le cas de la figure 1 avec les mêmes tensions de seuil 11, 12, 13, 14. Les commutateurs F1, F2, F3, F4 connectés en sortie des comparateurs sont commandés de la même façon.

La différence avec le dispositif de la figure 1 réside dans le fait que les résistances R0, R1, R2, R3, R4 permettant de faire varier la tension d'alimentation sont connectées en parallèle. Par ailleurs, chaque résistance n'est plus connectée en parallèle à son commutateur, ou transistor, associé mais est connectée en série. Ainsi, la résistance R0 est connectée entre le LNA et la tension $Vcc_{max}$, et pour les autres résistances, chaque résistance R1, R2, R3, R4 en série avec son commutateur F1, F2, F3, F4 est connectée entre le LNA et la tension $Vcc_{max}$. Une résistance R0' est connectée entre le LNA et le potentiel de masse.

Le principe de fonctionnement est le même que celui décrit précédemment sauf que la valeur de la tension d'alimentation du LNA n'est plus définie par des résistances en série mais par des résistances en parallèle. Un avantage de cette solution réside dans le partage du courant dans les transistors.

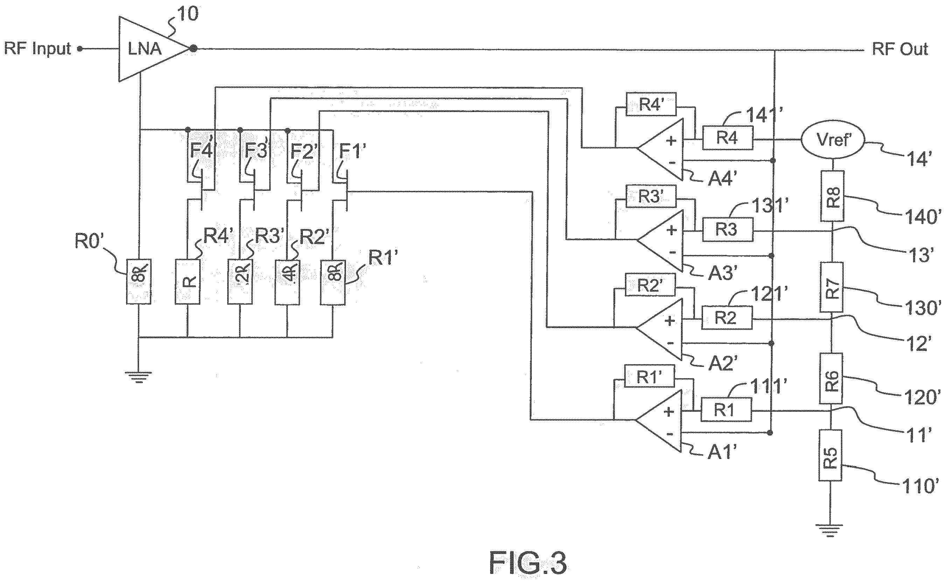

La figure 3 illustre un autre mode de mise en oeuvre possible de l'invention où le circuit d'asservissement est en courant uniquement. De façon analogue à la figure 2, les comparateurs constitués des amplificateurs A1', A2', A3', A4' montés en suiveur sont étagés comme dans le cas de la figure 1 avec les mêmes tensions de seuil 11', 12', 13', 14'. Les commutateurs F1', F2', F3', F4' connectés en sortie des comparateurs sont commandés de la même façon. Les résistances R0', R1', R2', R3', R4' permettant de faire varier le courant de polarisation sont connectées en parallèle. Par ailleurs, chaque résistance n'est plus connectée en parallèle à son commutateur, ou transistor, associé mais est connectée en série. Ainsi, la résistance R0' est connectée entre le LNA et le potentiel de masse, et pour les autres résistances, chaque résistance R1, R2, R3, R4 en série avec son commutateur F1, F2, F3, F4 est connectée entre le LNA et le potentiel de masse.

Le principe de fonctionnement est le même que celui décrit précédemment sauf que la valeur du courant de polarisation du LNA n'est plus définie par des résistances en série mais par des résistances en parallèle.

Comme dans l'exemple de la figure 1, on souhaite faire varier le courant de polarisation pour arriver à un courant maximal de 320 mA par dépassements des seuils successifs 11', 12', 13',14' de valeurs respectives V1, V2, V3, V4, ce courant maximal étant appliqué pour les signaux les plus forts.

Dans ce cas, les valeurs de résistances sont les suivantes :

- R0' = 8R
- R1' = 8R
- R2' = 4R
- R3' = 2R
- R4' = R.

Lorsque l'amplitude du signal de sortie est inférieure à la tension de seuil 11', de valeur V1, tous les transistors F1', F2', F3', F4' sont ouverts et la résistance de drain est égale à 8R, le courant de polarisation du LNA passant uniquement dans la résistance R0'.

Dès que l'amplitude du signal de sortie dépasse la tension V1, le transistor F1' se ferme, le courant de polarisation se partage alors entre R0' et R1', la résistance de drain est alors égale à 4R.

Par la suite, au fur et à mesure des franchissements de seuils successifs, la valeur de résistance de drain passe successivement à 2R, R et R/2. On obtient R/2 lorsque le seuil V4 est franchi, correspondant au cas des signaux forts. On détermine alors R de façon à obtenir un courant de drain égal à 360 mA.

Comme dans l'exemple de la figure 1, on peut prendre V1 = 1/4 V2, V2 = 1/4 V3 et V3 = 1/4 V4.

Comme pour la figure 2, un avantage de cette solution réside dans le partage du courant dans les transistors. Ces transistors peuvent ainsi être plus justement dimensionnés en ne passant que le minimum de courant.

Les circuits d'asservissement décrits par les figures 1, 2 et 3 comportent quatre seuils 11, 12, 13, 14 pour l'asservissement de la tension d'alimentation et quatre seuils 11', 12', 13', 14' pour l'asservissement du courant de polarisation. Il est bien sûr possible de prévoir un autre nombre de seuil en fonction de la finesse d'asservissement souhaitée. Dans tous les cas, quel que soit le nombre de seuils, les circuits aval composés des comparateurs et des commutateurs restent les mêmes.

Pour tous ces circuits d'asservissement, la commande de tension d'alimentation est réalisée par un simple sélecteur comme l'illustrent les figures, par court-circuit de transistors FET, ou de MEMs ou de tout autre système de commutation. La commande de courant de polarisation peut être réalisée par court-circuit de résistances à l'aide de transistors FET ou de MEMs ou de tout autre système de commutation, par des diodes Zener ou tout autre système de commande en courant, la commande étant discrète ou continue.

Les résistances d'ajustement de la tension ou du courant peuvent être montés en série ou en parallèle.

Le système peut être étendu en augmentant le nombre de comparateurs et de résistances d'ajustement en fonction de la discrétisation souhaitée. La commutation peut se faire avec des comparateurs de type trigger de Schmitt permettant de faire commuter à partir d'un seuil fixé par une tension de référence avec un niveau d'hystérésis réglable en fonction des résistances connectées à l'entrée non inversée des amplificateurs. Ainsi, on peut régler de façon connue le niveau d'hystérésis du premier comparateur en réglant les valeurs des résistances 111, 112 montées sur le premier amplificateur A1. Il en est de même pour tous les autres comparateurs. Un niveau d'hystérésis de 10% de la valeur du seuil peut être calculé et ainsi appliqué.

Les figures 4a, 4b et 4c illustrent les effets de la commutation par paliers de la tension d'alimentation d'un LNA conformément à ce qui a été décrit ci-dessus. La figure 4a présente l'amplitude Ve des signaux d'entrée en fonction du temps. La figure 4b illustre la tension d'alimentation VG du LNA variant par paliers 42 pour être ajustée à l'amplitude du signal d'entrée. Cette variation est obtenue par un asservissement par exemple par un des circuits du type de ceux des figures 1, 2 ou 3. La figure 4c présente la tension Vs en sortie du LNA. Toutes les figures ont la même échelle de temps, l'unité de temps étant la nanoseconde. La figure 4c montre que le front de montée de la tension de sortie est couché 43 par rapport au front de montée du signal d'entrée, augmentant le temps de montée d'environ 3 ns, le temps de montée du signal d'entrée étant de l'ordre de 20 ns. Cette dégradation du front est notamment due au temps d'établissement de la tension d'alimentation VG du LNA qui suit la tension d'entrée Ve, VG augmentant avec Ve.

Les largeurs d'impulsion peuvent être compensées en fonction de l'amplitude mesuré. La loi de compensation en amplitude et les corrections de largeur d'impulsions à appliquer sont dans cas par exemple stockées dans une table, pour un faible nombre de valeurs. Les valeurs retenues peuvent être les valeurs d'amplitude correspondant aux différents seuils 11, 12, 13, 14, 11', 12', 13', 14'.

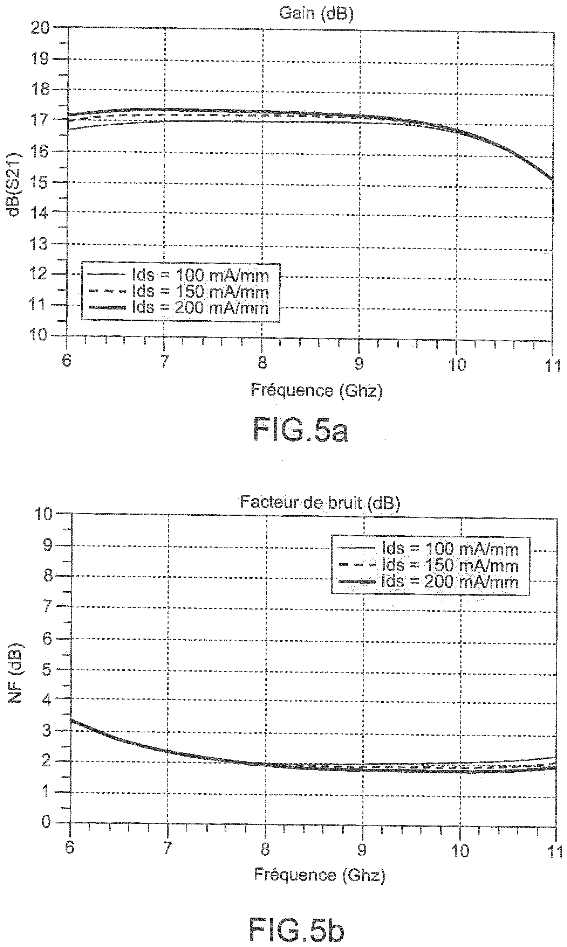

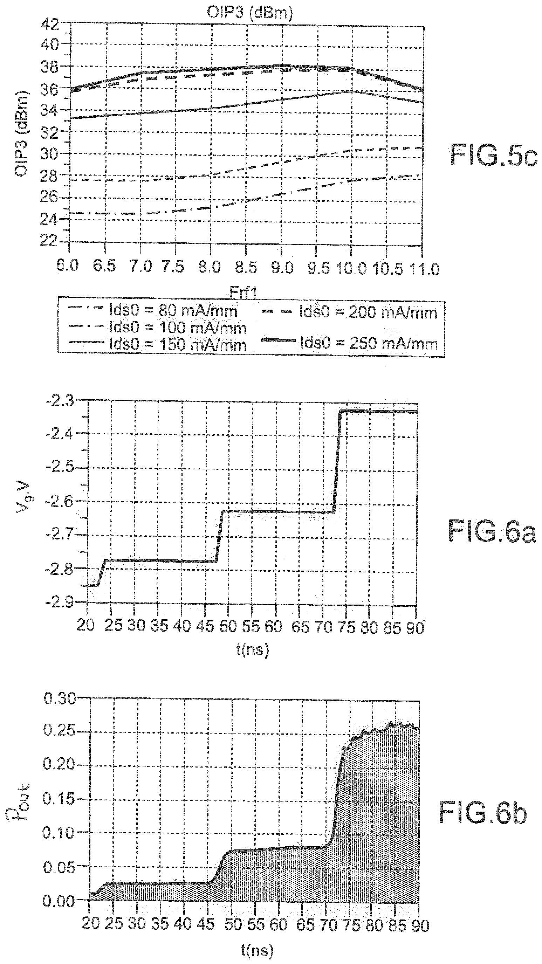

Les figures 5a, 5b et 5c montrent par des courbes respectivement la variation du gain en puissance, du facteur de bruit et des performances de linéarité (OIP3) en fonction du courant de polarisation, plus particulièrement du courant de drain Ids, exprimé en mA. Pour chaque figure, une courbe correspond à un niveau de courant Ids. Toutes ces courbes sont données pour une tension d'alimentation donnée du LNA. L'invention exploite avantageusement les résultats illustrés par ces courbes.

Les courbes de la figure 5a représentent le gain de transmission, correspondant au coefficient S21 de la fonction de transfert du LNA, exprimé en dB en fonction de la fréquence. La figure 5a présente à titre d'exemple trois courbes correspondant à Ids = 100 mA, Ids = 150 mA et Ids = 200 mA. Les courbes de la figure 5b représentent le facteur de bruit (NF) exprimé en dB en fonction de la fréquence pour ces trois mêmes valeurs de courant de polarisation.

Les courbes de la figure 5c présentent les performances de linéarité représentées par la grandeur IP3, exprimée en dBm, en fonction de la fréquence. La figures 5c comporte cinq courbes correspondant aux cinq valeurs suivantes du courant de polarisation Ids : 80 mA, 100 mA, 150 mA, 200 mA et 250 mA.

Ces courbes montrent clairement que les performances de gain et de bruit ne sont que très peu affectées par les modifications de consommation, fonction du courant Ids, alors qu'une dynamique de plus de 10 dBm est observée sur l'IP3.

Pour être efficace, il faut les temps de réaction du LNA pour passer d'un niveau de courant de polarisation à un autre n'excède pas quelques dizaines de nanosecondes, conformément aux figures 6a et 6b.

Ces figures 6a et 6b illustrent la commutation du signal pour plusieurs niveaux de tension de polarisation du LNA. La figure 6a illustre la tension De polarisation par une courbe en escalier fonction du temps, l'unité de temps étant la nanoseconde. L'amplitude du signal de sortie est illustrée par la figure 6b qui présente la puissance en fonction du temps, avec la même échelle de temps. La tension de polarisation varie par paliers en fonction de l'amplitude du signal de sortie.

Pour éviter toute saturation, dommageable dans une chaîne de réception ESM, une solution consiste à commuter très rapidement la commande du courant de polarisation pour n'entacher que le front de l'impulsion. En particulier, on peut contrôler directement la tension du LNA 10 et son courant de polarisation avec une fonction de transfert du signal de sortie, dans ce cas la marge de courant de polarisation doit être suffisante pour que les fronts des signaux ne soient pas saturant.

Il faut dans ce cas un circuit d'asservissement 1, 2 commutant rapidement pour éviter de saturer les fronts montant des signaux. Une solution possible peut consister à commuter les commutateurs, par exemple des transistors FET, par des niveaux de tension de sortie avec une hystérésis pour éviter le risque d'oscillation lors du passage des niveaux de consigne correspondant aux franchissement des seuils.

Un principe identique permet de revenir à des consommations moindres et de s'adapter à la dynamique strictement nécessaire, faisant ainsi des économies d'énergie. Cette fonction est importante pour les antennes actives. En effet, la formation du faisceau de réception par des déphaseurs et des modulateurs d'amplitude est dimensionnée pour le pire cas, ce qui entraîne une surconsommation multipliée par le nombre de modules nécessaires à la formation du faisceau. Une optimisation de cette chaîne entraîne donc des gains considérables dans l'énergie de mise en oeuvre.

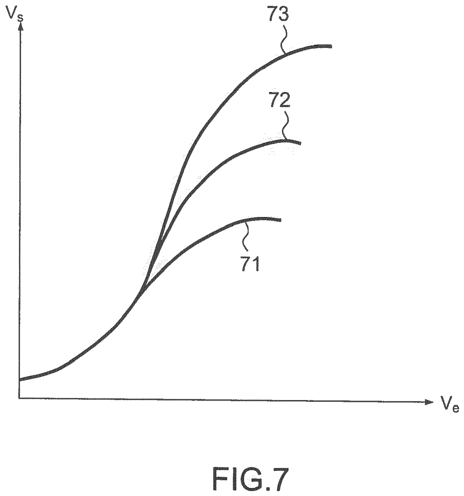

En fonction de la tension d'alimentation et de la tension de drain, le niveau de saturation évolue suivant des courbes différentes comme le montre la figure 7. Trois courbes 71, 72, 73 représentent le signal de sortie Vs en fonction du signal d'entrée Ve pour différentes valeurs de tensions d'alimentation et de courant de polarisation, ou courant drain. Lorsque la saturation est repoussée à la limite maximale 73, la consommation est aussi maximale. Une optimisation du paramétrage en courant et en tension est donc possible à condition d'avoir une boucle de réaction courte et de pouvoir anticiper les moments nécessitant une forte dynamique. La consommation peut par exemple varier d'un facteur 6 en fonction de la dynamique à traiter.

On pourrait considérer qu'un inconvénient de cette solution réside dans les fronts d'impulsion couchés liés au retard d'établissement de l'alimentation dans le cas de commutation de la tension d'alimentation ou au retard de l'établissement du courant de polarisation. En fonction des technologies, et dans le cadre d'une intégration de cette fonction dans un MMIC par exemple, les retards peuvent être considérés comme négligeables. De fait, les fronts des impulsions émises par les radars notamment ne sont pas parfaits et généralement leur temps de montée est de l'ordre de quelques nanosecondes, ce qui est homogène par rapport au temps de réaction des dispositifs préconisés.

La variation d'amplitude liée aux modifications des paramètres de polarisation du drain ou de modification de la tension d'alimentation du LNA (modulation de petits signaux) entraîne un effet Doppler sur les signaux lors d'une écoute de radars Doppler. Pour des applications ESM, un tel comportement n'est pas critique. Le temps de réaction pourrait coucher les fronts d'impulsion, entraînant une légère modification de la mesure de la largeur d'impulsion, ce qui n'est pas non plus critique.

Pour la mesure de temps d'arrivée dite TDOA (« Time Détection Of Arrivai »), si l'ensemble des signaux reçus sur toutes les antennes ont le même dispositif de gestion de la dynamique des signaux, les retards sont identiques et les mesures de temps d'arrivée relatifs peuvent se faire correctement quelles que soient les dynamiques des signaux, les mesures étant faites en relatif et non en absolu.

Avantageusement, on peut ajouter une mesure de la tension d'entrée du LNA 10 pour résister par ailleurs aux agressions externes. Ces agressions externes sont notamment produites par les signaux forts susceptibles de détruire le LNA. Les destructions sont notamment dues pics de tension (dV/dt) ou aux élévations de température. Le plus souvent ce type de composant est en effet détruit lorsque les surtensions à ses bornes induisent des niveaux des jonctions grille-drain, grille-source ou drain-sources supérieures aux tensions de claquages de ces jonctions. En ce qui concerne les élévations de température, elles sont notamment causées par des signaux au-delà de la saturation.

La mesure de la tension d'entrée du LNA permet de détection les surtensions et donc de réagir en cas de détection par une coupure de l'alimentation du LNA. Par ailleurs, en adjoignant à la mesure de la tension d'entrée un système de mesure de température de jonction ou d'intégration des impulsions reçues dans le temps permet de déterminer la valeur moyenne endurée par le composant de réagir en conséquence, notamment par une coupure de la tension d'alimentation. Un système de calcul de la puissance reçue est aussi une solution pour détecter une élévation de température.

## Revendications

1. Chaîne de réception de signaux électromagnétiques impulsionnels comportant un amplificateur faible bruit (10), ledit amplificateur faible bruit fonctionnant sous une tension d'alimentation et un courant de polarisation, ladite tension et/ou ledit courant étant asservis par au moins un circuit d'asservissement (1, 2) sur l'amplitude de chaque signal reçu dans ladite chaîne de réception, l'asservissement étant effectué à partir d'une mesure de ladite amplitude, **caractérisée en ce qu'**elle comprend un premier circuit d'asservissement (2) dudit courant de polarisation comportant N tensions de seuil (11', 12', 13', 14'), N étant supérieur à 1, chaque tension de seuil étant reliée à une entrée d'un comparateur d'un premier groupe de comparateurs (A1', A2', A3', A4'), l'autre entrée dudit comparateur étant reliée à la mesure de ladite amplitude des signaux, la sortie de chaque comparateur commandant un commutateur d'un premier groupe de commutateurs (F1', F2', F3', F4') court-circuitant une résistance d'un premier groupe de résistances (R'1, R'2, R'3, R'4) lorsque la mesure de ladite amplitude dépasse le seuil de tension relié audit commutateur, les résistances dudit premier groupe de résistances (R'1, R'2, R'3, R'4) étant reliées en série, l'ensemble desdites résistances conduisant ledit courant de polarisation en série avec une résistance de pied (R'0).

2. Chaîne de réception selon la revendication 1, **caractérisée en ce que** ladite résistance de pied (R'0) ayant une valeur R déterminant une valeur de courant de polarisation minimale, la résistance (R'1) commandée par le franchissement du premier seuil (11, V1) a une valeur égale à 2xNxR, la valeur d'une résistance (R'3) commandée par le franchissement d'un seuil donné étant la valeur de la résistance commandée par le franchissement du seuil immédiatement inférieur divisée par deux.

3. Chaîne de réception selon l'une quelconque des revendications précédentes, **caractérisée en ce qu'**elle comprend un deuxième circuit d'asservissement (1) de ladite tension d'alimentation comportant M tensions de seuil (11, 12, 13, 14), chaque tension de seuil étant reliée à une entrée d'un comparateur d'un deuxième groupe de comparateurs (A1, A2, A3, A4), l'autre entrée dudit comparateur étant reliée à la mesure de ladite amplitude des signaux, la sortie de chaque comparateur commandant un commutateur d'un deuxième groupe de commutateurs (F1, F2, F3, F4) court-circuitant une résistance d'un deuxième groupe de résistances (R1, R2, R3, R4) lorsque la mesure de ladite amplitude dépasse le seuil de tension relié audit commutateur, ledit amplificateur faible bruit (10) étant relié à une source de tension par les résistances dudit deuxième groupe de résistances (R1, R2, R3, R4) reliées en série.

4. Chaîne de réception de signaux électromagnétiques impulsionnels comportant un amplificateur faible bruit (10), ledit amplificateur faible bruit fonctionnant sous une tension d'alimentation et un courant de polarisation, ladite tension et/ou ledit courant étant asservis par au moins un circuit d'asservissement (1, 2) sur l'amplitude de chaque signal reçu dans ladite chaîne de réception, l'asservissement étant effectué à partir d'une mesure de ladite amplitude , **caractérisée en ce qu'**elle comprend un premier circuit d'asservissement dudit circuit de polarisation comportant N tensions de seuil (11', 12', 13', 14'), N étant supérieur à 1, chaque tension de seuil étant reliée à une entrée d'un comparateur d'un premier groupe de comparateurs (A1', A2', A3', A4'), l'autre entrée dudit comparateur étant reliée à la mesure de ladite amplitude des signaux, la sortie de chaque comparateur commandant un commutateur d'un premier groupe de comparateurs (F1', F2', F3', F4') en série avec une résistance d'un premier groupe de résistances (R1', R2', R3', R4'), ledit commutateur étant commandé à la fermeture lorsque la mesure de ladite amplitude dépasse le seuil de tension relié audit commutateur, les résistances dudit premier groupe de résistances (R1', R2', R3', R4') étant reliées en parallèle, l'ensemble desdites résistances conduisant ledit courant de polarisation en parallèle avec une autre résistance (R0').

5. Chaîne de réception selon la revendication 3, **caractérisée en ce que** ladite résistance de pied (R'0) ayant une valeur 2xNxR déterminant une valeur de courant de polarisation minimale, la résistance (R'1) commandée par le franchissement du premier seuil (11, V1) a une valeur égale à 2xNxR, la valeur d'une résistance (R'3) commandée par le franchissement d'un seuil donné étant la valeur de la résistance commandée par le franchissement du seuil immédiatement inférieur divisée par deux.

6. Chaîne de réception selon l'une quelconque des revendications 4 ou 5, **caractérisée en ce qu'**elle comprend un deuxième circuit d'asservissement (1) de ladite tension d'alimentation comportant M tensions de seuil (11, 12, 13, 14), chaque tension de seuil étant reliée à une entrée d'un comparateur d'un deuxième groupe de comparateurs (A1, A2, A3, A4), l'autre entrée dudit comparateur étant reliée à la mesure de ladite amplitude des signaux, la sortie de chaque comparateur commandant un commutateur d'un deuxième groupe de commutateurs (F1, F2, F3, F4) en série avec une résistance d'un deuxième groupe de résistances (R1, R2, R3, R4), ledit commutateur étant commandé à la fermeture lorsque la mesure de ladite amplitude dépasse le seuil de tension relié audit commutateur, ledit amplificateur faible bruit (10) étant relié à une source de tension par les résistances dudit deuxième groupe de résistances (R1, R2, R3, R4) reliées en parallèle.

7. Chaîne de réception selon l'une quelconque des revendications précédentes, **caractérisé en ce que** la comparaison de ladite amplitude avec ledit seuil est faite avec un cycle d'hystérésis.

8. Chaîne de réception selon l'une quelconque des revendications précédentes, **caractérisé en ce qu'**une correction d'amplitude et/ou une correction de largeur d'impulsion est appliquée à chaque impulsion, les corrections à appliquées étant préalablement stockées dans une table.

9. Chaîne de réception selon l'une quelconque des revendications précédentes, **caractérisé en ce que** ladite tension d'alimentation est coupée lorsque l'amplitude d'un signal reçu en entrée dudit amplificateur faible bruit dépasse un seuil de surtension donné.

10. Chaîne de réception selon l'une quelconque des revendications précédentes, **caractérisé en ce que** ladite tension d'alimentation est coupée lorsque la température de jonction grille-drain dudit amplificateur faible bruit dépasse un seuil donné.

**Patentansprüche**

1. Empfangskette von elektromagnetischen Impulssignalen, beinhaltend einen rauscharmen Verstärker (10), wobei der rauscharme Verstärker mit einer Versorgungsspannung und einem Polarisierungsstrom arbeitet, wobei die Spannung und/oder der Strom über mindestens einen Regelkreis (1, 2) anhand der Amplitude eines jeden in der Empfangskette empfangenen Signals geregelt wird/werden, wobei die Regelung anhand einer Messung der Amplitude erfolgt, **dadurch gekennzeichnet, dass** sie einen ersten Regelkreis (2) des Polarisierungs stroms beinhaltet, welcher N Schwellenspannungen (11', 12', 13', 14') beinhaltet, wobei N größer als 1 ist, wobei jede Schwellenspannung mit einem Eingang eines Vergleichers einer ersten Gruppe von Vergleichern (A1', A2', A3', A4') verbunden ist, wobei der andere Eingang des Vergleichers mit der Messung der Amplitude der Signale verbunden ist, wobei der Ausgang eines jeden Vergleichers einen Umschalter einer ersten Gruppe von Umschaltern (F1', F2', F3', F4') steuert, welcher einen Widerstand einer ersten Gruppe von Widerständen (R'1, R'2, R'3, R'4) kurzschließt, wenn die Messung der Amplitude die mit dem Umschalter verbundene Spannungsschwelle überschreitet, wobei die Widerstände der ersten Gruppe von Widerständen (R'1, R'2, R'3, R'4) in Reihe verbunden sind, wobei alle Widerstände den Polarisierungsstrom in Reihe mit einem Fußwiderstand (R'0) leiten.

2. Empfangskette nach Anspruch 1, **dadurch gekennzeichnet, dass**, da der Fußwiderstand (R'0) einen Wert R besitzt, welcher einen Polarisierungsstrom-Mindestwert bestimmt, der Widerstand (R'1), welcher von der Überschreitung der ersten Schwelle (11, V1) gesteuert wird, einen Wert gleich 2xNxR besitzt, wobei der Wert eines Widerstandes (R'3), welcher durch die Überschreitung einer gegebenen Schwelle gesteuert wird, der Wert des durch die Überschreitung der unmittelbar darunter gelegenen Schwelle gesteuerten Widerstandes geteilt durch zwei ist.

3. Empfangskette nach einem der vorhergehenden Ansprüche, **dadurch gekennzeichnet, dass** sie einen zweiten Regelkreis (1) der Versorgungsspannung beinhaltet, welche M Schwellenspannungen (11, 12, 13, 14) beinhaltet, wobei jede Schwellenspannung mit einem Eingang eines Vergleichers einer zweiten Gruppe von Vergleichern (A1, A2, A3, A4) verbunden ist, wobei der andere Eingang des Vergleichers mit der Messung der Amplitude der Signale verbunden ist, wobei der Ausgang eines jeden Vergleichers einen Umschalter einer zweiten Gruppe von Umschaltern (F1, F2, F3, F4) steuert, welcher einen Widerstand einer zweiten Gruppe von Widerständen (R1, R2, R3, R4) kurzschließt, wenn die Messung der Amplitude den mit dem Umschalter verbundenen Spannungsschwellenwert überschreitet, wobei der rauscharme Verstärker (10) mit einer Spannungsquelle über die Widerstände der zweiten Gruppe von Widerständen (R1, R2, R3, R4), welche in Reihe verbunden sind, verbunden ist.

4. Empfangskette von elektromagnetischen Impulssignalen, beinhaltend einen rauscharmen Verstärker (10), wobei der rauscharme Verstärker mit einer Versorgungsspannung und einem Polarisierungsstrom arbeitet, wobei die Spannung und/oder der Strom über mindestens einen Regelkreis (1, 2) anhand der Amplitude eines jeden in der Empfangskette empfangenen Signals geregelt wird/werden, wobei die Regelung anhand einer Messung der Amplitude erfolgt, **dadurch gekennzeichnet, dass** sie einen ersten Regelkreis des Polarisierungskreises beinhaltet, welcher N Schwellenspannungen (11', 12', 13', 14') beinhaltet, wobei N größer als 1 ist, wobei jede Schwellenspannung mit einem Eingang eines Vergleichers einer ersten Gruppe von Vergleichern (A1', A2', A3', A4') verbunden ist, wobei der andere Eingang des Vergleichers mit der Messung der Amplitude der Signale verbunden ist, wobei der Ausgang eines jeden Vergleichers einen Umschalter einer ersten Gruppe von Vergleichern (F1', F2', F3', F4') in Reihe mit einem Widerstand einer ersten Gruppe von Widerständen (R1', R2', R3', R4') steuert, wobei der Umschalter auf Schließen gesteuert wird, wenn die Messung der Amplitude den mit dem Umschalter verbundenen Spannungsschwellenwert überschreitet, wobei die Widerstände der ersten Gruppe von Widerständen (R1', R2', R3', R4') parallel verbunden sind, wobei sämtliche der Widerstände den Polarisierungsstrom parallel mit einem anderen Widerstand (R0') leiten.

5. Empfangskette nach Anspruch 3, **dadurch gekennzeichnet, dass**, da der Fußwiderstand (R'0) einen Wert 2xNxR besitzt, welcher einen Polarisierungsstrom-Mindestwert bestimmt, der Widerstand (R'1), welcher von der Überschreitung der ersten Schwelle (11, V1) gesteuert wird, einen Wert gleich 2xNxR besitzt, wobei der Wert eines Widerstandes (R'3), welcher durch die Überschreitung einer gegebenen Schwelle gesteuert wird, der Wert des durch die Überschreitung der unmittelbar darunter gelegenen Schwelle gesteuerten Widerstandes geteilt durch zwei ist.

6. Empfangskette nach einem der vorhergehenden Ansprüche 4 oder 5, **dadurch gekennzeichnet, dass** sie einen zweiten Regelkreis (1) der Versorgungsspannung beinhaltet, welche M Schwellenspannungen (11, 12, 13, 14) beinhaltet, wobei jede Schwellenspannung mit einem Eingang eines Vergleichers einer zweiten Gruppe von Vergleichern (A1, A2, A3, A4) verbunden ist, wobei der andere Eingang des Vergleichers mit der Messung der Amplitude der Signale verbunden ist, wobei der Ausgang jedes Vergleichers einen Umschalter einer zweiten Gruppe von Umschaltern (F1, F2, F3, F4) in Reihe mit einem Widerstand einer zweiten Gruppe von Widerständen (R1, R2, R3, R4) steuert, wobei der Umschalter auf Schließen gesteuert wird, wenn die Messung der Amplitude den mit dem Umschalter verbundenen Spannungsschwellenwert überschreitet, wobei der rauscharme Verstärker (10) mit einer Spannungsquelle über die Widerstände der zweiten Gruppe von Widerständen (R1, R2, R3, R4), welche parallel verbunden sind, verbunden ist.

7. Empfangskette nach einem der vorhergehenden Ansprüche, **dadurch gekennzeichnet, dass** der Vergleich der Amplitude mit der Schwelle mit einem Hysteresezyklus erfolgt.

8. Empfangskette nach einem der vorhergehenden Ansprüche, **dadurch gekennzeichnet, dass** eine Korrektur der Amplitude und/oder eine Korrektur der Impulsbreite auf jeden Impuls angewandt wird/werden, wobei die anzuwendenden Korrekturen vorab in einer Tabelle gespeichert wurden.

9. Empfangskette nach einem der vorhergehenden Ansprüche, **dadurch gekennzeichnet, dass** die Versorgungsspannung getrennt wird, wenn die Amplitude eines am Eingang des rauscharmen Verstärkers empfangenen Signals eine gegebene Überspannungsschwelle überschreitet.

10. Empfangskette nach einem der vorhergehenden Ansprüche, **dadurch gekennzeichnet, dass** die Versorgungsspannung getrennt wird, wenn die Verbindungstemperatur zwischen Drain und Gate des rauscharmen Verstärkers eine gegebene Schwelle überschreitet.

**Claims**

1. A reception chain for electromagnetic pulse signals comprising a low-noise amplifier (10), said low-noise amplifier operating under a supply voltage and a bias current, said voltage and/or said current being controlled by at least one control circuit (1, 2) as a function of the amplitude of each signal received in said reception chain, the control being carried out on the basis of a measurement of said amplitude, **characterised in that** it comprises a first circuit (2) for controlling said bias current comprising N threshold voltages (11', 12', 13', 14'), with N being greater than 1, each threshold voltage being connected to an input of a comparator of a first group of comparators (A1', A2', A3', A4'), the other input of said comparator being connected to the measurement of said amplitude of the signals, the output of each comparator controlling a switch of a first group of switches (F1', F2', F3', F4') short-circuiting a resistor of a first group of resistors (R'1, R'2, R'3, R'4) when the measurement of said amplitude exceeds the threshold voltage connected to said switch, the resistors of said first group of resistors (R'1, R'2, R'3, R'4) being connected in series, the set of said resistors conducting said bias current in series with a base resistor (R'0).

2. The reception chain as claimed in claim 1, **characterised in that**, with said base resistor (R'0) having a value R determining a minimum bias current value, the resistor (R'1) that is controlled when the first threshold (11, V1) is crossed has a value equal to 2xNxR, with the value of a resistor (R'3) that is controlled when a given threshold is crossed being the value of the resistor that is controlled when the threshold immediately below is crossed, divided by two.

3. The reception chain as claimed in any one of the preceding claims, **characterised in that** it comprises a second circuit (1) for controlling said supply voltage comprising M threshold voltages (11, 12, 13, 14), each threshold voltage being connected to an input of a comparator of a second group of comparators (A1, A2, A3, A4), the other input of said comparator being connected to the measurement of said amplitude of the signals, the output of each comparator controlling a switch of a second group of switches (F1, F2, F3, F4) short-circuiting a resistor of a second group of resistors (R1, R2, R3, R4) when the measurement of said amplitude exceeds the threshold voltage connected to said switch, said low-noise amplifier (10) being connected to a voltage source by the resistors of said second group of resistors (R1, R2, R3, R4) connected in series.

4. The reception chain for electromagnetic pulse signals comprising a low-noise amplifier (10), said low-noise amplifier operating under a supply voltage and a bias current, said voltage and/or said current being controlled by at least one control circuit (1, 2) as a function of the amplitude of each signal received in said reception chain, the control being carried out on the basis of a measurement of said amplitude, **characterised in that** it comprises a first circuit for controlling said bias circuit comprising N threshold voltages (11', 12', 13', 14'), with N being greater than 1, each threshold voltage being connected to an input of a comparator of a first group of comparators (A1', A2', A3', A4'), the other input of said comparator being connected to the measurement of said amplitude of the signals, the output of each comparator controlling a switch of a first group of comparators (F1', F2', F3', F4') in series with a resistor of a first group of resistors (R1', R2', R3', R4'), said switch being controlled to close when the measurement of said amplitude exceeds the threshold voltage connected to said switch, the resistors of said first group of resistors (R1', R2', R3', R4') being connected in parallel, the set of said resistors conducting said bias current in parallel with another resistor (R0').

5. The reception chain as claimed in claim 3, **characterised in that**, with said base resistor (R'0) having a value 2xNxR determining a minimum bias current value, the resistor (R'1) that is controlled when the first threshold (11, V1) is crossed has a value equal to 2xNxR, with the value of a resistor (R'3) that is controlled when a given threshold is crossed being the value of the resistor that is controlled when the threshold immediately below is crossed, divided by two.

6. The reception chain as claimed in any one of claims 4 or 5, **characterised in that** it comprises a second circuit (1) for controlling said supply voltage comprising M threshold voltages (11, 12, 13, 14), each threshold voltage being connected to an input of a comparator of a second group of comparators (A1, A2, A3, A4), the other input of said comparator being connected to the measurement of said amplitude of the signals, the output of each comparator controlling a switch of a second group of switches (F1, F2, F3, F4) in series with a resistor of a second group of resistors (R1, R2, R3, R4), said switch being controlled to close when the measurement of said amplitude exceeds the threshold voltage connected to said switch, said low-noise amplifier (10) being connected to a voltage source by the resistors of said second group of resistors (R1, R2, R3, R4) connected in parallel.

7. The reception chain as claimed in any one of the preceding claims, **characterised in that** said amplitude is compared to said threshold using a hysteresis cycle.

8. The reception chain as claimed in any one of the preceding claims, **characterised in that** an amplitude correction and/or a pulse width correction is applied to each pulse, with the corrections to be applied being previously stored in a table.

9. The reception chain as claimed in any one of the preceding claims, **characterised in that** said supply voltage is cut when the amplitude of a signal received at the input of said low-noise amplifier exceeds a given overvoltage threshold.

10. The reception chain as claimed in any one of the preceding claims, **characterised in that** said supply voltage is cut when the gate-drain junction temperature of said low-noise amplifier exceeds a given threshold.

FIG.1

FIG.2

EP 3 235 124 B1

FIG.3

EP 3 235 124 B1

FIG.4a

FIG.4b

FIG.4c

FIG.5a

FIG.5b

FIG.5c

FIG.6a

FIG.6b

FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013307615 A1
- US 2009042527 A1
- US 2009215420 A1